# EUROPEAN PATENT SPECIFICATION

(11) **EP 2 725 581 B1**
(45) Date of publication and mention of the grant of the patent: **15.05.2019**
(21) Application number: 13187910.8
(22) Date of filing: 09.10.2013
(51) Int. Cl.: G11C 19/28

(54) **Shift register and method for driving the same, gate driving device, display device and electronic product**
Schieberegister und Verfahren zur Ansteuerung davon, Gate-Ansteuerungsvorrichtung, Anzeigevorrichtung und elektronisches Produkt
Registre à décalage et son procédé de commande, dispositif de commande de grille, dispositif d'affichage et produit électronique

(30) Priority: 29.10.2012 CN 201210421295
(43) Date of publication of application: 30.04.2014
(73) Proprietor: BOE Technology Group Co., Ltd., Beijing 100015 (CN)
(72) Inventor: Liu, Yaohu, 100176 Beijing (CN)
(74) Representative: Isarpatent

(56) References cited:
- US-A1- 2004 109 526
- US-A1- 2005 134 545
- US-A1- 2011 044 423
- US-A1- 2012 113 088
- US-A1- 2012 188 210
- US-B1- 6 556 646

## Description

### BACKGROUND OF THE INVENTION

### FIELD OF THE INVENTION

The embodiments of the present invention relate to a display field, and more particularly to a shift register, a gate driving device, a display device and an electronic product.

### DESCRIPTION OF THE PRIOR ART

In a flat panel display, a fundamental principle for displaying a frame of picture is that a source driver outputs data signals to a data line and a gate driver outputs a square waveform with a certain width to a gate line sequentially from top to bottom so as to enable the gate.

In the conventional producing process, a gate driving IC and a source driving IC are bonded on a glass panel by a COG (Chip On Glass) process.

However, in the gate driving structure of the prior art, the output of the Nth line is commonly used as a reset signal for the N-1th line, which results in that the gate driving structure is complicated and power consumption is high.

US2004/0109526 relates a shift register having a built-in level shifter. The shift register includes a buffer outputting a shift pulse using a first clock signal and a first supply voltage via voltages at first and second nodes; a first controller controlling the voltage of the first node via the start pulse and the second node; and a second controller controlling the second node voltage using the first and second supply voltage via the start pulse and the second clock signal.

US2011/0044423 relates to a shift register includes a plurality of electrically connected shift units. Each shift unit includes a pull-up circuit, a pull-up driving circuit, a pull-down circuit and a pull-down driving circuit.

US2012/0188210 relates a gate driving circuit unit, a gate driving circuit and a display device. The gate driving circuit unit comprises: a first clock signal control module, an input signal control module, a third clock signal control module and a fourth clock signal control module, wherein the first clock signal control module comprises a driving unit and a clock feed-through suppressing unit.

US2005/0134545 relates a gate driving apparatus for a liquid crystal display. The gate driving apparatus includes a shift register which is provided with first and second half-period clock signals having phases inverted with respect to each other and each having a pulse width of a half-period, first to fourth one-period clock signals having phases shifted sequentially and each having a pulse width of one period, a start pulse, a high-level supply voltage and a low-level supply voltage.

US2012/0113088 discloses that a shift register increases a number of thin film transistor s for lowing drive and a manner of alternatively applying clock signals every other frame, lowers duty cycle of the thin film transistors for lowing drive, and effectively prevents a biasing effect by the thin film transistors for lowering drive, thereby reliability of the shift register unit is guaranteed.

CN 101 853 705 discloses a disc burner, in particular, a NOR type FLASH U disk burner. The burner aims to support more Flash types without connecting a computer
US 6 556 646 B1 disclose a shift register for driving a pixel row in a liquid crystal display device. In the shift register, a plurality of stages are connected to a high level voltage source, a low level voltage source and a phase-delayed clock signal generator, connected to row lines, and connected, in cascade, with respect to a scanning signal, for charging and discharging the row lines

### SUMMARY OF THE INVENTION

The present invention aims to provide a shift register for driving the same, a gate driving device, a display device and an electronic product, so that the gate driving structure can be simplified and the power consumption of the gate driving can be reduced.

This is achieved by the features of the independent claim.

A gate driving device of the invention comprises multiple stages of shift registers as claimed except for the last stage of shift registers, each gate signal output terminal of remaining stages of shift registers is coupled to a gate signal input terminal of the next stage of shift registers.

A display device of the invention comprises the gate as described above.

An electronic product of the invention comprises the display device as described above.

### BRIEF DESCRIPTION OF THE DRAWINGS

The present invention will be more clearly understood from the description of preferred embodiments as set forth below, with reference to the accompanying drawings, wherein:
Fig. 1 is the first schematic circuit diagram of a shift register according to an embodiment of the present invention;
Fig. 2 is a schematic structure diagram of a charging unit according to an embodiment of the present invention;
Fig. 3 is the second schematic circuit diagram of a shift register according to an example not covered by the claims;
Fig. 4 is a schematic structure diagram of a pull-up unit according to an embodiment of the present invention;
Fig. 5 is a schematic structure diagram of a pull-down unit according to an embodiment of the present invention;
Fig. 6 is a sequential chart of a shift register according to an embodiment of the present invention;
Fig. 7 is the third schematic circuit diagram of a shift register according to an embodiment of the present invention;
Fig. 8 is a schematic flowchart of a method for driving a shift register according to an embodiment of the present invention;
Fig. 9 is the first schematic structure diagram of a gate driving device according to an embodiment of the present invention;
Fig. 10 is the first sequential chart of a gate driving device according to an embodiment of the present invention;
Fig. 11 is the second schematic structure diagram of a gate driving device according to an embodiment of the present invention; and
Fig. 12 is the second sequential chart of a gate driving device according to an embodiment of the present invention.

### DETAILED DESCRIPTION OF THE PREFERRED EMBODIMENTS

In order to clearly set forth the aim, technical solutions and advantages of embodiments of the present disclosure, the embodiments of the present disclosure are further described in conjunction with drawings and embodiments. The embodiments of the present invention are only used for illustration and explanation, and are not used to limit the present invention.

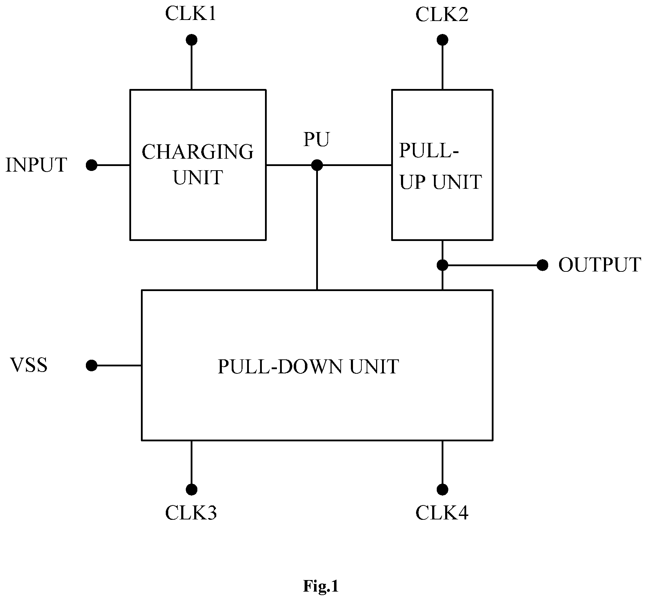

As shown in Fig. 1, an embodiment of the present invention provides a shift register which comprises:

A charging unit 11, a pull-up unit 12, a pull-down unit 13, a gate signal input terminal INPUT, a DC low level signal input terminal VSS, a first clock signal input terminal CLK1, a second clock signal input terminal CKL 2, a third clock signal input terminal CLK3, a fourth clock signal input terminal CLK4 and a gate signal output terminal OUTPUT.

The charging unit 11 may be coupled to the gate signal input terminal INPUT, the first clock signal input terminal CLK1, the pull-up unit 12 and the pull-down unit 13 respectively so as to control a potential of a pull-up node PU as a high level during a charging phase.

The pull-up unit 12 may be coupled to the charging unit 11, the pull-down unit 13, the second clock signal input terminal CKL 2 and the gate signal output terminal OUTPUT respectively so as to output a high level signal input by the second clock signal input terminal to the gate signal output terminal.

The pull-down unit 13 may be coupled to the charging unit 11, the pull-up unit 12, the DC low level signal input terminal VSS, the third clock signal input terminal CLK3 and the fourth clock signal input terminal CLK4 respectively so as to control potentials of the pull-up node PU and the gate signal output terminal OUTPUT as a low level during both a reset phase and a reset maintaining phase.

The shift register provided in the embodiment of the present invention may be a GOA (Gate Driver On Array) circuit. Since a structure having four clock signal input terminals is adopted, such structure can solve the problem for resetting signals, it is not necessary to use an output signal of a shift register in the next row as a reset signal in the shift register provided in the embodiment of the present invention, so that the gate driving structure can be simplified.

Furthermore, since the structure having four clock signal input terminals is adopted, the frequency thereof is decreased. According to the power calculation equation P=a^{∗}C^{∗}V^2^{∗}F (where a is a power factor, C is a capacitance, V is a voltage and F is a frequency), when other parameters are constant, since the frequency is decreased, power of the shift register and power of the gate driving device can be relatively reduced.

The clock signals input by the four clock signal input terminals according to the embodiment of the present invention may be high level signals which are alternately input in a certain period. For example, a first clock signal, a second clock signal, a third clock signal and a fourth clock signal are high level signals that are input sequentially. In one embodiment, in the first phase, that is a charging phase, the gate signal input terminal inputs a gate signal, in the mean time, the first clock signal input terminal inputs a high level, while the second, the third and the fourth clock signal input terminal input a low level respectively. In the second phase, that is an output phase, the gate signal input terminal stops inputting, the first, the third and the fourth clock signal input terminals input a low level, while the second clock signal input terminal inputs a high level. In the third phase, that is a reset phase, the first, the second and the fourth clock signal input terminals input a low level and the third clock signal input terminal inputs a high level. Finally in the reset maintaining phase, the first, the second and the third clock signal input terminals input a low level and the fourth clock signal input terminal inputs a high level.

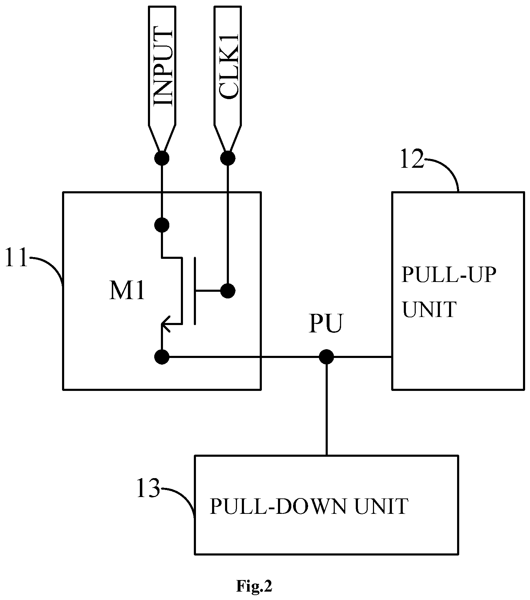

As shown in Fig. 2, the charging unit according to an embodiment of the present invention may comprise a first thin film transistor M1.

The source of the first thin film transistor M1 is coupled to the gate signal input terminal. The gate of the first thin film transistor M1 is coupled to the first clock signal terminal CLK1. The drain of the first thin film transistor M1 is coupled to the pull-up unit 12 and the pull-down unit 13 respectively via the pull-up node PU.

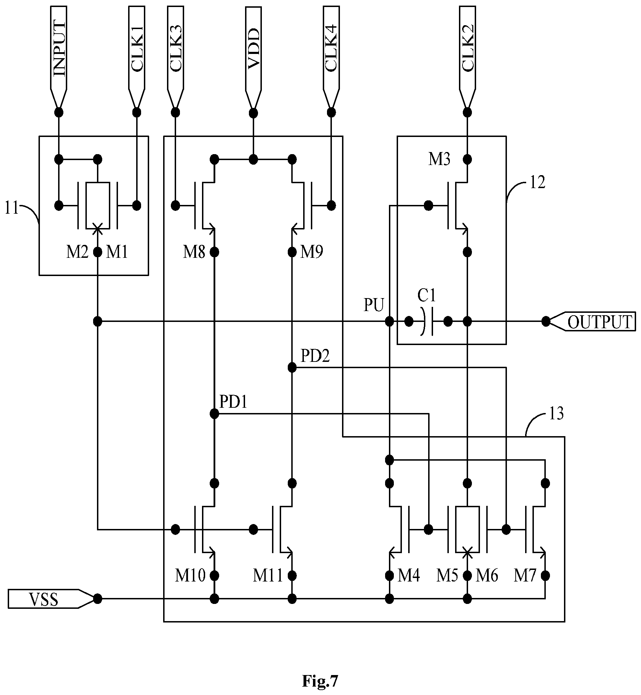

In another embodiment of the present invention, as shown in Fig.7 (Fig.7 shows a specific form of shift register according to an embodiment of the present invention), the charging unit 11 according to the embodiment of the present invention further comprises a second thin film transistor M2. That is, the charging unit comprises a first thin film transistor M1 and a second thin film transistor M2.

The source of the first thin film transistor M1 is coupled to the gate signal input terminal INPUT, the gate of the first thin film transistor M1 is coupled to the first clock signal input terminal CLK1, and the drain of the first thin film transistor M1 is coupled to the pull-up unit 12 and the pull-down unit 13 respectively via the pull-up node PU.

The source and the gate of the second thin film transistor M2 are coupled to the gate signal input terminal INPUT, the drain of the second thin film transistor M2 is coupled to the pull-up unit 12 and the pull-down unit 13 respectively via the pull-up node PU.

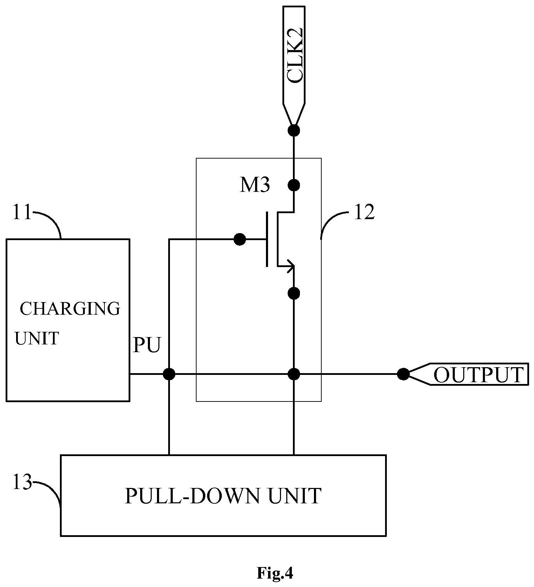

As shown in Fig. 4, the pull-up unit 12 according to the embodiment of the present invention comprises a third thin film transistor M3.

The source of the third thin film transistor M3 is coupled to the second clock signal input terminal CLK2, the gate of the third thin film transistor M3 is coupled to the charging unit 11 and the pull-down unit 13 respectively via the pull-up node PU, and the drain of the third thin film transistor M3 is coupled to the gate signal output terminal OUTPUT and the pull-down unit 13 respectively.

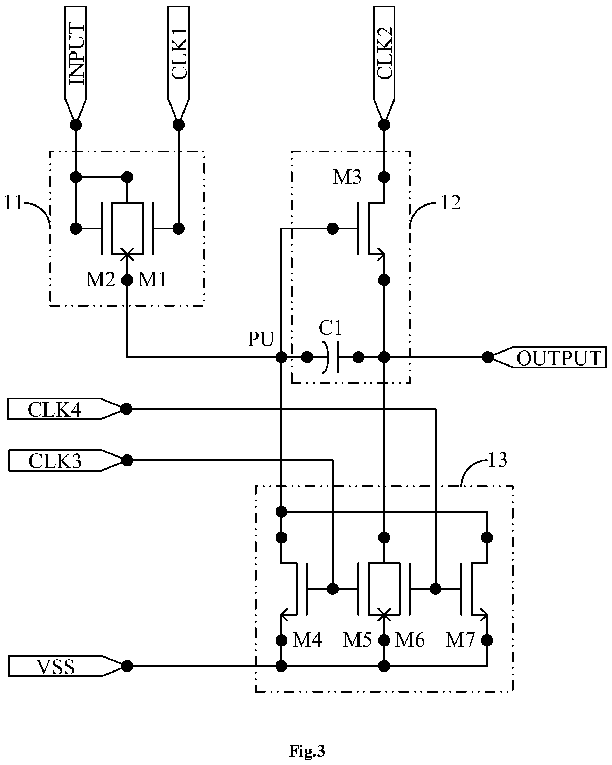

In one preferred embodiment, the pull-up unit 11 may further comprise a storage capacitor C1. As shown in Fig.7, the first terminal of C1 (referring to the left terminal shown in Fig. 3) may connect the gate of the third thin film transistor M3, the charging unit 11 and the pull-down unit 13 via the pull-up node PU, the second terminal of C1 (referring to the right terminal shown in Fig.7) is coupled to the gate signal output terminal OUTPUT and the pull-down unit 13.

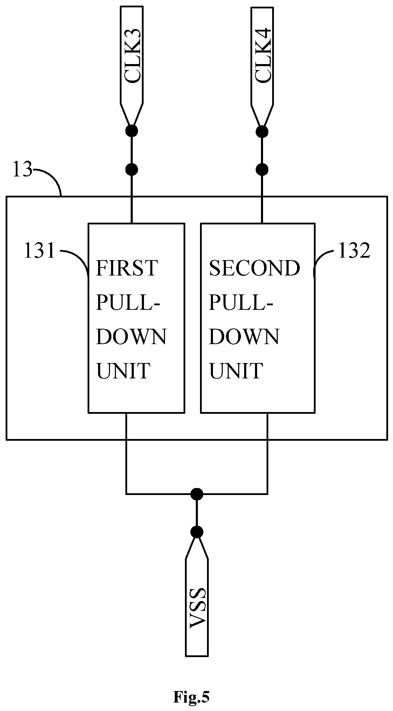

As shown in Fig. 5, the pull-down unit 13 according to the embodiment of the present invention may comprise a first pull-down unit 131 and a second pull-down unit 132.

The first pull-down unit 131 is coupled to the third clock signal input terminal CLK3 and the DC low level signal input terminal VSS respectively so as to control potentials of the pull-up node PU and the gate signal output terminal OUTPUT as a low level during a reset phase.

The second pull-down unit 132 is coupled to the fourth clock signal input terminal CLK4 and the DC low level signal input terminal VSS respectively so as to control potentials of the pull-up node PU and the gate signal output terminal OUTPUT as a low level during a reset maintaining phase.

In one preferred embodiment, as shown in Fig. 7, the first pull-down unit 131 (not shown in Fig. 7) may comprise a fourth thin film transistor M4 and a fifth thin film transistor M5.

The source of the fourth thin film transistor M4 is coupled to the charging unit 11 and the pull-up unit 12 respectively via the pull-up node PU. The gate of the fourth thin film transistor M4 is coupled to the third clock signal input terminal CLK3. The drain of the fourth thin film transistor M4 is coupled to the DC low level signal input terminal VSS.

The source of the fifth thin film transistor M5 is coupled to the pull-up unit 12 and the gate signal output terminal OUTPUT respectively via the pull-up node PU. The gate of the fifth thin film transistor M5 is coupled to the third clock signal input terminal CLK3. The drain of the fifth thin film transistor M5 is coupled to the DC low level signal input terminal VSS.

Similarly, in the preferred embodiment as shown in Fig. 7, the second pull-down unit 132 (not shown in Fig. 7) may comprise a sixth thin film transistor M6 and a seventh thin film transistor M7.

The source of the sixth thin film transistor M6 is coupled to the pull-up unit 12 and the gate signal input terminal INPUT respectively. The gate of the sixth thin film transistor M6 is coupled to the fourth clock signal input terminal CLK4. The drain of the sixth thin film transistor M6 is coupled to the DC low level signal input terminal VSS.

The source of the seventh thin film transistor M7 is coupled to the charging unit 11 and the pull-up unit 12 respectively via the pull-up node PU. The gate of the seventh thin film transistor M7 is coupled to the fourth clock signal input terminal CLK4. The drain of the seventh thin film transistor is coupled to the DC low level signal input terminal VSS.

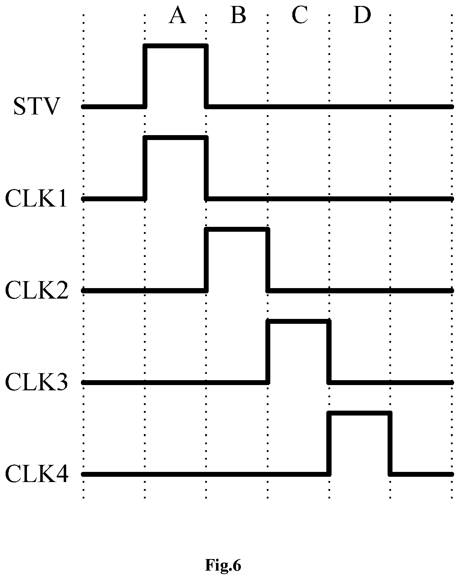

Fig. 6 shows a sequential chart of the shift register according to an embodiment of the present invention. STV is a start signal that is used as a gate input signal of the first stage of shift register. The gate signals output by output terminals OUTPUT of a previous stage of shift registers are used as a gate (INPUT) input signal for remaining stages (except for the first stage) of shift registers.

Based on the sequential chart shown in Fig. 6, the specific process of the shift register according to the embodiment of the present invention is as follows.

During a charging phase (that is phase A in Fig. 6), INPUT inputs STV, CLK1 inputs a high level (that is an input clock signal), CLK2, CLK 3, CLK 4 input a low level. At that time, M1 and M2 are turned on, e.g. in ON state and other thin film transistors (i.e., M3, M4, M5, M6 and M7) are in cut-off state , e.g. OFF state. The charging unit 11 controls the potential of the pull-up node as a high level, and the charging unit 11 starts to charge C1.

During an output phase (that is phase B in Fig. 6), INPUT stops inputting, CLK1, CLK3 and CLK4 input a low level. CLK2 inputs a high level so that M3 is in ON state (other thin film transistors are in cut-off state). The clock signal input from CLK2 pull the potential of the pull-up node PU high again by the coupling effect of M3. That is, the pull-up unit 12 controls the potential of the pull-up node PU as a high level. That is, the pull-up unit 12 controls the clock signal input from CLK 2 so as to output it to the gate signal output terminal OUTPUT, and the gate signal output terminal OUTPUT outputs a high level, that is to output a gate signal.

During the reset phase (that is phase C in Fig. 6, the normal output of the gate signal output terminal OUTPUT completes), CLK1, CLK2 and CLK4 input a low level, CLK3 inputs a high level so that M4 and M5 are in ON state. Therefore, the pull-up node PU and the gate signal output terminal OUTPUT are in discharging state, that is, the pull down unit 13(specifically, may be the first pull-down unit 131) controls the potentials of the pull-up node PU and the gate signal output terminal OUTPUT as a low level. At this time, other thin film transistors are in cut-off state.

During reset maintaining phase (that is phase D in Fig. 6), CLK1, CLK2 and CLK3 input a low level, CLK4 inputs a high level, so that M6 and M7 are in On state (other thin film transistors are in cut-off state). Therefore, the pull-up node PU and the gate signal output terminal OUTPUT are kept as a low level, that is the pull-down unit 13 (specifically may be the second pull-down unit 132) continuously controls the potentials of the pull-up node PU and the gate signal output terminal OUTPUT as a low level during the reset maintaining phase.

In the embodiment of the present invention, since CLK3 and CLK4 input high levels respectively during the reset phase and the reset maintaining phase, M4, M5 and M6, M7 alternately turn on (that in being ON state). Therefore, the pull-up node PU and the gate signal output terminal OUTPUT are kept as a low level during the above two phases so as to remove noise.

The shift register having the structure shown in Fig. 3 has the advantage of occupying less area and being beneficial for a narrow frame design.

In an embodiment of the present invention, the shift register is shown in Fig. 7.

In the embodiment shown in Fig. 7, the shift register according to an embodiment of the present invention may further comprise a DC high level signal input terminal VDD.

In the shift register shown in Fig. 7, the circuit configurations of the charging unit 11 and the pull-up unit 12 are the same as that in the above shift register according to an embodiment of the present invention. However, the circuit configuration of the pull-down unit 13 has structural changes differing from that of the above embodiment.

In the embodiment of the present invention as shown in Fig. 7, the first pull-down unit 131 (not shown in figures) comprised in the pull-down unit 13 may comprise a fourth thin film transistor M4, a fifth thin film transistor M5, an eighth thin film transistor M8 and a tenth thin film transistor M10.

The source of the fourth thin film transistor M4 is coupled to the charging unit 11, the pull-up unit 12 and the gate of the tenth thin film transistor respectively via the pull-up node PU. The gate of the fourth thin film transistor M4 is coupled to the drain of the eighth thin film transistor M8 and the source of the tenth thin film transistor M10 respectively. The drain of the fourth thin film transistor M4 is coupled to the DC low level signal input terminal VSS.

The source of the fifth thin film transistor M5 is coupled to the pull-up unit 12 and the gate signal output terminal OUTPUT respectively. The gate of the fifth thin film transistor M5 is coupled to the drain of the eighth thin film transistor M8 and the source of the tenth thin film transistor M10 respectively. The drain of the fifth thin film transistor M5 is coupled to the DC low level signal input terminal VSS.

The source of the eighth thin film transistor M8 is coupled to the DC high level signal input terminal VDD. The gate of the eighth thin film transistor M8 is coupled to the third clock signal input terminal CLK3. The drain of the eighth thin film transistor M8 is coupled to the gate of the fourth thin film transistor M4, the gate of the fifth thin film transistor M5 and the source of the tenth thin film transistor M10 respectively.

The connection between the source and the gate of the tenth thin film transistor M10 has been illustrated and will not be repeated herein. The drain of M10 is coupled to the DC low level signal input terminal VSS.

In the embodiment shown in Fig. 7, the second pull-down unit 132 (not shown in figures) comprised in the pull-down unit 13 may comprise a sixth thin film transistor M6, a seventh thin film transistor M7, a ninth thin film transistor M9 and an eleventh thin film transistor M11.

The source of the sixth thin film transistor M6 is coupled to the pull-up unit 12 and the gate signal output terminal OUTPUT respectively. The gate of the sixth thin film transistor M6 is coupled to the drain of the ninth thin film transistor M9 and the source of the eleventh thin film transistor M11 respectively. The drain of the sixth thin film transistor M6 is coupled to the DC low level signal input terminal VSS.

The source of the seventh thin film transistor M7 is coupled to the charging unit 11, the pull-up unit 12 and the gate of the eleventh thin film transistor M11 respectively via the pull-up node PU. The gate of the seventh thin film transistor M7 is coupled to the drain of the ninth thin film transistor M9 and the source of the eleventh thin film transistor M11 respectively. The drain of the seventh thin film transistor M7 is coupled to the DC low level signal input terminal VSS.

The source of the ninth thin film transistor M9 is coupled to the DC high level signal input terminal VDD. The gate of the ninth thin film transistor M9 is coupled to the fourth clock signal input terminal CLK4. The drain of the ninth thin film transistor M9 is coupled to the gate of the sixth thin film transistor M6, the gate of the seventh thin film transistor M7 and the source of the eleventh thin film transistor M11 respectively.

The connection between the source and the gate of the eleventh thin film transistor M11 has been illustrated and will not be repeated herein. The drain of M11 is coupled to the DC low level signal input terminal VSS.

The shift register as shown in Fig. 7 according to an embodiment of the present invention may operate based on the sequential chart shown in Fig. 6. The specific process may be as follows.

During a charging phase, INPUT inputs STV, CLK1 inputs a high level, CLK2, CLK 3, CLK 4 input a low level. At that time, M1, M2, M10 and M11 are in ON state and other thin film transistors (M3-M9) are in cut-off state. The charging unit 11 controls the potential of the pull-up node as a high level, the charging unit 11 starts to charge C1. Since M10 and M11 are in ON state, the first pull-down node PD1 and the second pull-down node PD2 are in low level.

During the output phase, INPUT stops inputting, CLK1, CLK3 and CLK4 input a low level. CLK2 inputs a high level so that M3, M10 and M11 are in ON state. The clock signal input from CLK2 pull the potential of the pull-up node PU high again by the coupling effect of M3. That is, the pull-up unit 12 controls the potential of the pull-up node PU as a high level. The clock signal input from CLK2 outputs to the gate signal output terminal OUTPUT, and the gate signal output terminal OUTPUT outputs a high level. Since M10 and M11 are in ON state, the first pull-down node PD1 and the second pull-down node PD2 are in a low level.

During the reset phase, CLK1, CLK2 and CLK4 input a low level, CLK3 inputs a high level so that M8, M4 and M5 are in ON state. Therefore, the pull-up node PU and the gate signal output terminal OUTPUT are in discharging state, that is, the pull-down unit 13 (specifically, may be the first pull-down unit 131) controls the potentials of the pull-up node PU and the gate signal output terminal OUTPUT as a low level. At this time, other thin film transistors are in cut-off state.

During the reset maintaining phase, CLK1, CLK2 and CLK3 input a low level, CLK4 inputs a high level, so that M9, M6 and M7 are in ON state (other thin film transistors are in cut-off state). Therefore, the pull-up node PU and the gate signal output terminal OUTPUT are kept as a low level, that is the pull-down unit 13 (specifically may be the second pull-down unit 132) continuously controls the potentials of the pull-up node PU and the gate signal output terminal OUTPUT as a low level during the reset maintaining phase.

In the embodiment as shown in Fig. 7, during the reset phase and the reset maintaining phase, CLK3 and CLK4 input a high level respectively so that M8, M4, M5 and M9, M6, M7 alternately turn on. Therefore, the pull-up node PU and the gate signal output terminal OUTPUT are kept as a low level during the above two phases so as to remove noise alike.

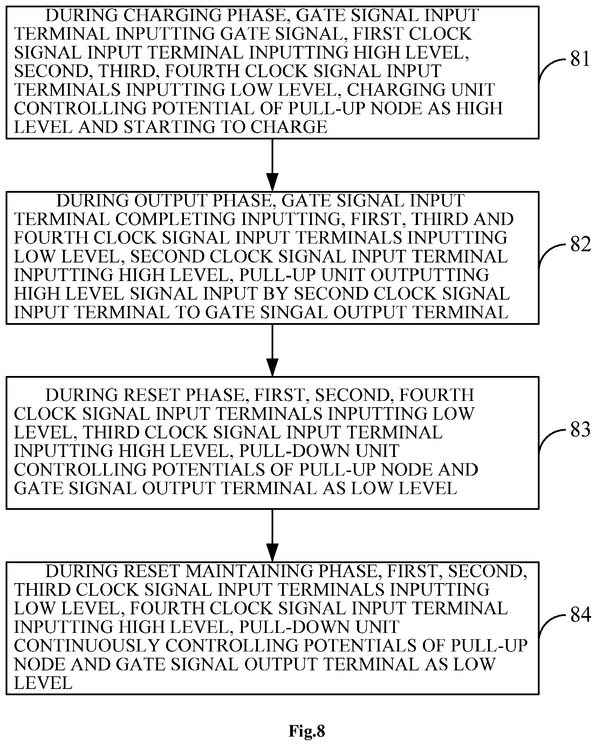

The embodiments of the present invention may further provide a method for driving a shift register. The method is used for the shift register according to the embodiments of the present invention. As shown in Fig. 8, the method may comprise:
Step 81, during a charging phase, a gate signal input terminal inputting a gate signal, a first clock signal input terminal inputting a high level, a second, a third, a fourth clock signal input terminals inputting a low level, a charging unit controlling a potential of the pull-up node as a high level and starting to charge;
Step 82, during an output phase, the gate signal input terminal completing inputting, the first, the third and the fourth clock signal input terminals inputting a low level, the second clock signal input terminal inputting a high level, the pull-up unit outputting the high level signal input by the second clock signal input terminal to a gate signal output terminal;
Step 83, during a reset phase, the first, the second, the fourth clock signal input terminals inputting a low level, the third clock signal input terminal inputting a high level, a pull-down unit controlling potentials of a pull-up node and the gate signal output terminal as a low level; and
Step 84, during a reset maintaining phase, the first, the second, the third clock signal input terminals inputting a low level, the fourth clock signal input terminal inputting a high level, the pull-down unit continuously controlling the potentials of the pull-up node and the gate signal output terminal as a low level.

The embodiment of the present invention may provide a gate driving device, comprising multiple stages of shift registers as shown in Figs. 1, 2 or 4 according to the embodiments of the present invention that are manufactured on a glass substrate of a liquid crystal display (LCD).

Specifically, except for the last stage of shift registers, each gate signal output terminal of remaining stages of shift registers may be coupled to a gate signal input terminal of the next stage of shift registers.

The gate driving device according to the embodiments of the present invention may be configured to have two kinds of structures: a one-side driving structure and a dual-side driving structure.

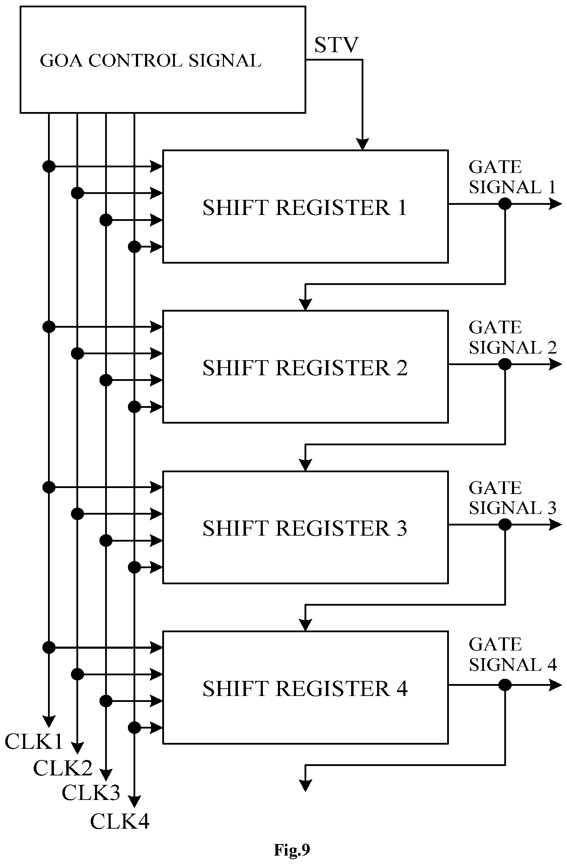

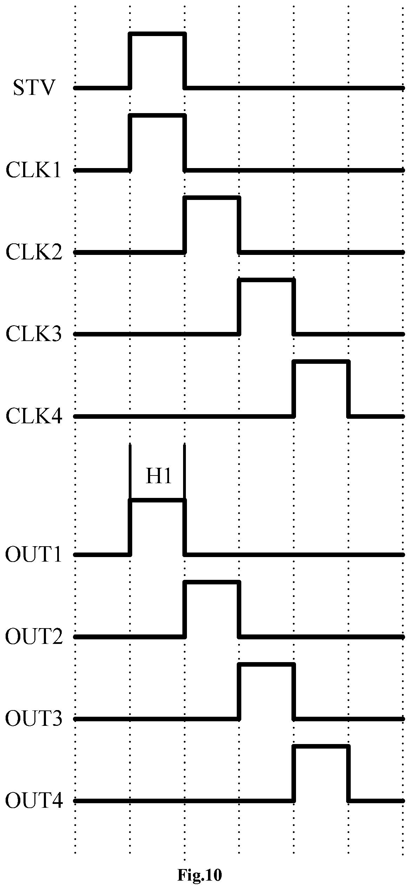

The schematics structure of the one-side driving is shown in Fig. 9 and the sequential chart thereof is shown in Fig. 10.

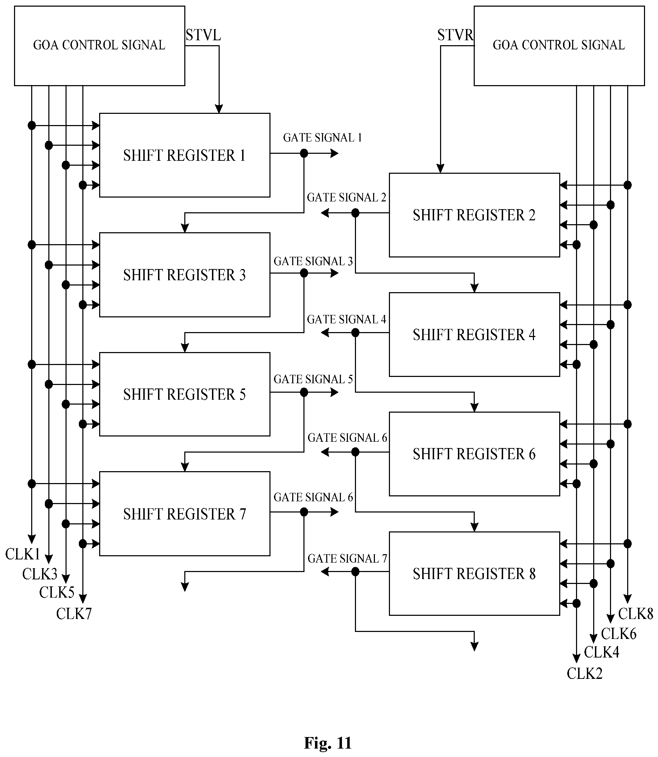

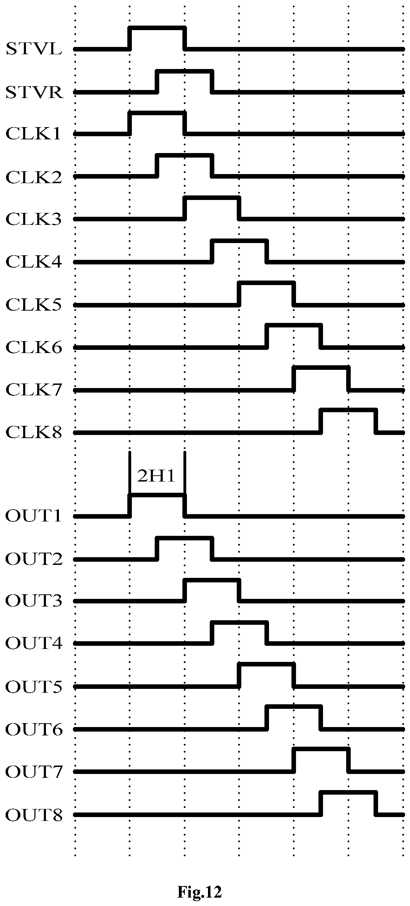

On the other hand, the schematic structure of the dual-side driving is shown in Fig. 11 and the sequential chart thereof is shown in Fig. 12.

Noted that, as shown in Fig. 10, H1=1/F/L, where F represents a picture refreshing rate, L represents a number of lines. For example, for a display having a resolution of 480^{∗}800, L represents 800. However, when a picture is displayed, there is a format issue. Therefore, L is slightly larger than 800 during a practical calculation. Of course, both F and L may take any other suitable values, which is not limited only to those disclosed by the embodiments of the present invention. As shown in Fig. 12, 2H1 represents twice as H1, and the filling-in part represents a valid time. Furthermore, as also shown in Fig. 12, STVL represents a gate input signal at the left side of the dual-side driving structure, and STVR represents a gate input signal at the right side of the dual-side driving structure.

Both the one-side driving structure and the dual-side driving structure as illustrated in the above embodiments of the present invention are also applicable to the shift registers as shown in Fig. 1, 2 or 4 according to the embodiments of the present invention. Further, these two driving structures may be also applied to other kinds of known or unknown shift registers, rather than being limited to those disclosed by the embodiments of the present invention.

The embodiment of the present invention may also provide a display device comprising a gate driving device according to the above embodiments of the present invention.

The display device may be a liquid crystal panel, a liquid crystal TV, a liquid crystal display, an OLED panel, an OLED display, a plasma display or an electrical paper and so on. However, the type of the display device is not limited to these. The gate driving device according to the above embodiments of the present invention may also be applied to other types of known or unknown display devices.

Further, the embodiment of the present invention may also provide an electronic product, which comprises any one of display devices disclosed by the embodiments of the present invention.

The shift register, the gate driving device and the display device according to the embodiments of the present invention are suitable for GOA circuit requirement under a low temperature poly-silicon (LTPS) process and are also suitable for a GOA circuit under an amorphous silicon process.

From the above description, the embodiments of the present invention provide a shift register and a method for driving the same, a gate driving device and a display device. A charging unit, a pull-up unit, a pull-down unit, a gate signal input terminal, a DC low level signal input terminal, a gate signal output terminal and a first, a second, a third, a fourth clock signal input terminals may be arranged within the shift register, so that the gate driving structure can be simplified and the power consumption of the gate driving can be reduced.

The above mentioned are only the embodiments of the present disclosure, which is not intended to limit the protection scope of the present disclosure. Thus any change, alternative, and modification within the scope of the appended claims should belong to the scope of protection of the present disclosure.

## Claims

1. A shift register, comprising a charging unit (11), a pull-up unit (12), a pull-down circuit (13), a gate signal input terminal (INPUT), a DC low level signal input terminal (VSS), a first clock signal input terminal (CLK1), a second clock signal input terminal (CLK2), a third clock signal input terminal (CLK3), a fourth clock signal input terminal (CLK4) and a gate signal output terminal (OUTPUT), wherein
the charging unit (11) is coupled to the gate signal input terminal (INPUT), the first clock signal input terminal (CLK1), the pull-up unit (12) and the pull-down circuit (13) respectively so as to control a potential of a pull-up node (PU) to a high level in response to a first clock signal provided on the first clock signal input terminal (CLK1) during a charging phase;
the pull-up unit (12) is coupled to the charging unit (11), the pull-down circuit (13), the second clock signal input terminal (CLK2) and the gate signal output terminal (OUTPUT) respectively so as to output the high level signal input by the second clock signal input terminal (CLK2) to the gate signal output terminal (OUTPUT) under control of potentials on the pull-up node (PU) during an output phase; and
the pull-down circuit (13) is coupled to the charging unit (11), the pull-up unit (12), the DC low level signal input terminal (VSS), the third clock signal input terminal (CLK3) and the fourth clock signal input terminal (CLK4) respectively so as to control potentials of the pull-up node (PU) and the gate signal output terminal (OUTPUT) to a low level during a reset phase and a reset maintaining phase,
the pull-down circuit (13) comprises a first pull-down unit (131) and a second pull-down unit (132), the first pull-down unit (131) is coupled to the third clock signal input terminal (CLK3) and the DC low level signal input terminal (VSS) respectively so as to control potentials of the pull-up node (PU) and the gate signal output terminal (OUTPUT) to the low level during the reset phase; and the second pull-down unit (132) is coupled to the fourth clock signal input terminal (CLK4) and the DC low level signal input terminal (VSS) respectively so as to control potentials of the pull-up node (PU) and the gate signal output terminal (OUTPUT) to the low level during the reset maintaining phase,
the shift register further comprises a DC high level signal input terminal (VDD);
**characterized in that**
the first pull-down unit (131) comprises a fourth thin film transistor (M4), a fifth thin film transistor (M5), an eighth thin film transistor (M8) and a tenth thin film transistor (M10), wherein the source of the fourth thin film transistor (M4) is coupled to the charging unit (11), the pull-up unit (12) and the gate of the tenth thin film transistor (M10) respectively via the pull-up node (PU), the gate of the fourth thin film transistor (M4) is coupled to the drain of the eighth thin film transistor (M8) and the source of the tenth thin film transistor (M10) respectively, and the drain of the fourth thin film transistor (M4) is coupled to the DC low level signal input terminal (VSS); the source of the fifth thin film transistor (M5) is coupled to the pull-up unit (12) and the gate signal output terminal (OUTPUT) respectively, the gate of the fifth thin film transistor (M5) is coupled to the drain of the eighth thin film transistor (M8) and the source of the tenth thin film transistor (M10) respectively, and the drain of the fifth thin film transistor (M5) is coupled to the DC low level signal input terminal (VSS); the source of the eighth thin film transistor (M8) is coupled to the DC high level signal input terminal (VDD), the gate of the eighth thin film transistor (M8) is coupled to the third clock signal input terminal (CLK3), and the drain of the eighth thin film transistor (M8) is coupled to the gate of the fourth thin film transistor (M4), the gate of the fifth thin film transistor (M5) and the source of the tenth thin film transistor (M10) respectively; and the drain of the tenth thin film transistor (M10) is coupled to the DC low level signal input terminal (VSS); and
the second pull-down unit (132) comprises a sixth thin film transistor (M6), a seventh thin film transistor (M7), a ninth thin film transistor (M9) and an eleventh thin film transistor (M11), wherein the source of the sixth thin film transistor (M6) is coupled to the pull-up unit (12) and the gate signal output terminal (OUTPUT) respectively, the gate of the sixth thin film transistor (M6) is coupled to the drain of the ninth thin film transistor (M9) and the source of the eleventh thin film transistor (M11) respectively, the drain of the sixth thin film transistor (M6) is coupled to the DC low level signal input terminal (VSS); the source of the seventh thin film transistor (M7) is coupled to the charging unit (11), the pull-up unit (12) and the gate of the eleventh thin film transistor (M11) respectively via the pull-up node (PU), the gate of the seventh thin film transistor (M7) is coupled to the drain of the ninth thin film transistor (M9) and the source of the eleventh thin film transistor (M11) respectively, the drain of the seventh thin film transistor (M7) is coupled to the DC low level signal input terminal (VSS); the source of the ninth thin film transistor (M9) is coupled to the DC high level signal input terminal (VDD), the gate of the ninth thin film transistor (M9) is coupled to the fourth clock signal input terminal (CLK4), the drain of the ninth thin film transistor (M9) is coupled to the gate of the sixth thin film transistor (M6), the gate of the seventh thin film transistor (M7) and the source of the eleventh thin film transistor (M11) respectively; and the drain of the eleventh thin film transistor (M11) is coupled to the DC low level signal input terminal (VSS).

2. The shift register according to claim 1, wherein the charging unit (11) comprises a first thin film transistor (M1), wherein the source of the first thin film transistor (M1) is coupled to the gate signal input terminal (INPUT), the gate of the first thin film transistor (M1) is coupled to the first clock signal input terminal (CLK1), and the drain of the first thin film transistor (M1) is coupled to the pull-up unit (12) and the pull-down circuit (13) respectively via the pull-up node (PU).

3. The shift register according to claim 1, wherein the charging unit (11) comprises a first thin film transistor (M1) and a second thin film transistor (M2), wherein
the source of the first thin film transistor (M1) is coupled to the gate signal input terminal (INPUT), the gate of the first thin film transistor (M1) is coupled to the first clock signal input terminal (CLK1), and the drain of the first thin film transistor (M1) is coupled to the pull-up unit (12) and the pull-down circuit (13) respectively via the pull-up node (PU);
the source and the gate of the second thin film transistor (M2) are coupled to the gate signal input terminal (INPUT), the drain of the second thin film transistor (M2) is coupled to the pull-up unit (12) and the pull-down circuit (13) respectively via the pull-up node (PU).

4. The shift register according to any one of claims 1-3, wherein the pull-up unit (12) comprises a third thin film transistor (M3), wherein the source of the third thin film transistor (M3) is coupled to the second clock signal input terminal (CLK2), the gate of the third thin film transistor (M3) is coupled to the charging unit (11) and the pull-down circuit (13) respectively via the pull-up node (PU), and the drain of the third thin film transistor (M3) is coupled to the gate signal output terminal (OUTPUT) and the pull-down circuit (13) respectively.

5. The shift register according to any one of claims 1-4, wherein the pull up unit (12) further comprises a storage capacitor (C1), wherein a first terminal of the storage capacitor (C1) is coupled to the gate of the third thin film transistor (M3), the charging unit (11) and the pull-down circuit (13) via the pull-up node (PU), while a second terminal of the storage capacitor (C1) is coupled to the drain of the third thin film transistor (M3), the gate signal output terminal (OUTPUT) and the pull-down circuit (13) respectively.

6. A gate driving device, **characterized in** comprising multiple stages of shift registers according to any one of claims 1-5;
except for the last stage of shift registers, each gate signal output terminal (OUTPUT) of remaining stages of shift registers is coupled to a gate signal input terminal (INPUT) of the next stage of shift registers.

7. A display device, **characterized in** comprising the gate driving device according to claim 6.

8. An electronic product, **characterized in** comprising the display device according to claim 7.

## Patentansprüche

1. Schieberegister, das eine Ladeeinheit (11), eine Pull-up-Einheit (12), eine Pull-down-Schaltung (13), einen Gate-Signal-Eingangsanschluss (INPUT), einen Tiefpegel-Gleichspannungssignal-Eingangsanschluss (VSS), einen ersten Taktsignal-Eingangsanschluss (CLK1), einen zweiten Taktsignal-Eingangsanschluss (CLK2), einen dritten Taktsignal-Eingangsanschluss (CLK3), einen vierten Taktsignal-Eingangsanschluss (CLK4) und einen Gate-Signal-Ausgangsanschluss (OUTPUT) enthält, wobei
die Ladeeinheit (11) mit dem Gate-Signal-Eingangsanschluss (INPUT), dem ersten Taktsignal-Eingangsanschluss (CLK1), der Pull-up-Einheit (12) und der Pull-down-Schaltung (13) so gekoppelt ist, dass sie während einer Ladephase in Reaktion auf ein erstes Taktsignal, das am ersten Taktsignal-Eingangsanschluss (CLK1) bereitgestellt wird, ein Potential eines Pull-up-Knotens (PU) auf einen Hochpegel steuern kann;
die Pull-up-Einheit (12) mit der Ladeeinheit (11), der Pull-down-Schaltung (13), dem zweiten Taktsignal-Eingangsanschluss (CLK2) und dem Gate-Signal-Ausgangsanschluss (OUTPUT) gekoppelt ist, um das Hochpegelsignal, das durch den zweiten Taktsignal-Eingangsanschluss (CLK2) unter der Steuerung von Potentialen am Pull-up-Knoten (PU) in den Gate-Signal-Ausgangsanschluss (OUTPUT) eingegeben wird, während einer Ausgangsphase auszugeben; und
die Pull-down-Schaltung (13) mit der Ladeschaltung (11), der Pull-up-Einheit (12), dem Tiefpegel-Gleichspannungssignal-Eingangsanschluss (VSS), dem dritten Taktsignal-Eingangsanschluss (CLK3) und dem vierten Taktsignal-Eingangsanschluss (CLK4) gekoppelt ist, um Potentiale des Pull-up-Knotens (PU) und des Gate-Signal-Ausgangsanschlusses (OUTPUT) während einer Rücksetzphase und einer Rücksetzhaltephase auf einen Tiefpegel zu steuern,
die Pull-down-Schaltung (13) eine erste Pull-down-Einheit (131) und eine zweite Pull-down-Einheit (132) umfasst, wobei die erste Pull-down-Einheit (131) mit dem dritten Taktsignal-Eingangsanschluss (CLK3) und dem Tiefpegel-Gleichspannungssignal-Eingangsanschluss (VSS) gekoppelt ist, um Potentiale des Pull-down-Knotens (PU) und des Gate-Signal-Ausgangsanschlusses (OUTPUT) während der Rücksetzphase auf den Tiefpegel zu steuern; und wobei die zweite Pull-down-Einheit (132) mit dem vierten Taktsignal-Eingangsanschluss (CLK4) und dem Tiefpegel-Gleichspannungssignal-Eingangsanschluss (VSS) gekoppelt ist, um Potentiale des Pull-up-Knotens (PU) und des Gate-Signal-Ausgangsanschlusses (OUTPUT) während der Rücksetzhaltephase auf den Tiefpegel zu steuern,
wobei das Schieberegister ferner einen Hochpegel-Gleichspannungssignal-Eingangsanschluss (VDD) enthält;
**dadurch gekennzeichnet, dass**
die erste Pull-down-Einheit (131) einen vierten Dünnschichttransistor (M4), einen fünften Dünnschichttransistor (M5), einen achten Dünnschichttransistor (M8) und einen zehnten Dünnschichttransistor (M10) umfasst, wobei die Source des vierten Dünnschichttransistors (M4) mit der Ladeeinheit (11), der Pull-up-Einheit (12) und dem Gate des zehnten Dünnschichttransistors (M10) über den Pull-up-Knoten (PU) gekoppelt ist, das Gate des vierten Dünnschichttransistors (M4) mit dem Drain des achten Dünnschichttransistors (M8) und der Source des zehnten Dünnschichttransistors (M10) gekoppelt ist und der Drain des vierten Dünnschichttransistors (M4) mit dem Tiefpegel-Gleichspannungssignal-Eingangsanschluss (VSS) gekoppelt ist; wobei die Source des fünften Dünnschichttransistors (M5) mit der Pull-up-Einheit (12) und dem Gate-Signal-Ausgangsanschluss (OUTPUT) gekoppelt ist, das Gate des fünften Dünnschichttransistors (M5) mit dem Drain des achten Dünnschichttransistors (M8) und der Source des zehnten Dünnschichttransistors (M10) gekoppelt ist und der Drain des fünften Dünnschichttransistors (M5) mit dem Tiefpegel-Gleichspannungssignal-Eingangsanschluss (VSS) gekoppelt ist; wobei die Source des achten Dünnschichttransistors (M8) mit dem Hochpegel-Gleichspannungssignal-Eingangsanschluss (VDD) gekoppelt ist, das Gate des achten Dünnschichttransistors (M8) mit dem dritten Taktsignal-Eingangsanschluss (CLK3) gekoppelt ist und der Drain des achten Dünnschichttransistors (M8) mit dem Gate des vierten Dünnschichttransistors (M4), dem Gate des fünften Dünnschichttransistors (M5) und der Source des zehnten Dünnschichttransistors (M10) gekoppelt ist; und wobei der Drain des zehnten Dünnschichttransistors (M10) mit dem Tiefpegel-Gleichspannungssignal-Eingangsanschluss (VSS) gekoppelt ist; und
die zweite Pull-down-Einheit (132) einen sechsten Dünnschichttransistor (M6), einen siebten Dünnschichttransistor (M7), einen neunten Dünnschichttransistor (M9) und einen elften Dünnschichttransistor (M11) enthält, wobei die Source des sechsten Dünnschichttransistors (M6) mit der Pull-up-Einheit (12) und dem Gate-Signal-Ausgangsanschluss (OUTPUT) gekoppelt ist, das Gate des sechsten Dünnschichttransistors (M6) mit dem Drain des neunten Dünnschichttransistors (M9) und der Source des elften Dünnschichttransistors (M11) gekoppelt ist, der Drain des sechsten Dünnschichttransistors (M6) mit dem Tiefpegel-Gleichspannungssignal-Eingangsanschluss (VSS) gekoppelt ist; wobei die Source des siebten Dünnschichttransistors (M7) mit der Ladeeinheit (11), der Pull-up-Einheit (12) und dem Gate des elften Dünnschichttransistors (M11) über den Pull-up-Knoten (PU) gekoppelt ist, das Gate des siebten Dünnschichttransistors (M7) mit dem Drain des neunten Dünnschichttransistors (M9) und der Source des elften Dünnschichttransistors (M11) gekoppelt ist, der Drain des siebten Dünnschichttransistors (M7) mit dem Tiefpegel-Gleichspannungssignal-Eingangsanschluss (VSS) gekoppelt ist; die Source des neunten Dünnschichttransistors (M9) mit dem Hochpegel-Gleichspannungssignal-Eingangsanschluss (VDD) gekoppelt ist, das Gate des neunten Dünnschichttransistors (M9) mit dem vierten Taktsignal-Eingangsanschluss (CLK4) gekoppelt ist, der Drain des neunten Dünnschichttransistors (M9) mit dem Gate des sechsten Dünnschichttransistors (M6), dem Gate des siebten Dünnschichttransistors (M7) und der Source des elften Dünnschichttransistors (M11) gekoppelt ist; und der Drain des elften Dünnschichttransistors (M11) mit dem Tiefpegel-Gleichspannungssignal-Eingangsanschluss (VSS) gekoppelt ist.

2. Schieberegister nach Anspruch 1, wobei die Ladeeinheit (11) einen ersten Dünnschichttransistor (M1) enthält, wobei die Source des ersten Dünnschichttransistors (M1) mit dem Gate-Signal-Eingangsanschluss (INPUT) gekoppelt ist, das Gate des ersten Dünnschichttransistors (M1) mit dem ersten Taktsignal-Eingangsanschluss (CLK1) gekoppelt ist und der Drain des ersten Dünnschichttransistors (M1) mit der Pull-up-Einheit (12) und der Pull-down-Schaltung (13) über den Pull-up-Knoten (PU) gekoppelt ist.

3. Schieberegister nach Anspruch 1, wobei die Ladeeinheit (11) einen ersten Dünnschichttransistor (M1) und einen zweiten Dünnschichttransistor (M2) enthält, wobei
die Source des ersten Dünnschichttransistors (M1) mit dem Gate-Signal-Eingangsanschluss (INPUT) gekoppelt ist, das Gate des ersten Dünnschichttransistors (M1) mit dem ersten Taktsignal-Eingangsanschluss (CLK1) gekoppelt ist und der Drain des ersten Dünnschichttransistors (M1) mit der Pull-up-Einheit (12) und der Pull-down-Schaltung (13) über den Pull-up-Knoten (PU) gekoppelt ist; und
die Source und das Gate des zweiten Dünnschichttransistors (M2) mit dem Gate-Signal-Eingangsanschluss (INPUT) gekoppelt ist und der Drain des zweiten Dünnschichttransistors (M2) mit der Pull-up-Einheit (12) und der Pull-down-Schaltung (13) über den Pull-up-Knoten (PU) gekoppelt ist.

4. Schieberegister nach einem der Ansprüche 1-3, wobei die Pull-up-Einheit (12) einen dritten Dünnschichttransistor (M3) enthält, wobei die Source des dritten Dünnschichttransistors (M3) mit dem zweiten Taktsignal-Eingangsanschluss (CLK2) gekoppelt ist, das Gate des dritten Dünnschichttransistors (M3) mit der Ladeeinheit (11) und der Pull-down-Schaltung (13) über den Pull-up-Knoten (PU) gekoppelt ist und der Drain des dritten Dünnschichttransistors (M3) mit dem Gate-Signal-Ausgangsanschluss (OUTPUT) und der Pull-down-Schaltung (13) gekoppelt ist.

5. Schieberegister nach einem der Ansprüche 1-4, wobei die Pull-up-Einheit (12) einen Speicherkondensator (C1) enthält, wobei der erste Anschluss des Speicherkondensators (C1) mit dem Gate des dritten Dünnschichttransistors (M3), der Ladeeinheit (11) und der Pull-down-Schaltung (13) über den Pull-up-Knoten (PU) gekoppelt ist, während ein zweiter Anschluss des Speicherkondensators (C1) mit dem Drain des dritten Dünnschichttransistors (M3), dem Gate-Signal-Ausgangsanschluss (OUTPUT) und der Pull-down-Schaltung (13) gekoppelt ist.

6. Gate-Ansteuervorrichtung, **dadurch gekennzeichnet, dass** sie mehrere Stufen von Schieberegistern nach einem der Ansprüche 1-5 enthält,
wobei mit Ausnahme der letzten Stufe der Schieberegister jeder Gate-Signal-Ausgangsanschluss (OUTPUT) der verbleibenden Stufen von Schieberegistern mit einem Gate-Signal-Eingangsanschluss (INPUT) der nächsten Stufe von Schieberegistern gekoppelt ist.

7. Anzeigevorrichtung, **gekennzeichnet durch** die Gate-Ansteuervorrichtung nach Anspruch 6.

8. Elektronisches Produkt, **gekennzeichnet durch** die Anzeigevorrichtung nach Anspruch 7.

## Revendications

1. Registre à décalage, comprenant une unité de charge (11), une unité d'élévation (12), un circuit d'abaissement (13), une borne d'entrée de signal de grille (INPUT), une borne d'entrée de signal de bas niveau DC (VSS), une première borne d'entrée de signal d'horloge (CLK1), une deuxième borne d'entrée de signal d'horloge (CLK2), une troisième borne d'entrée de signal d'horloge (CLK3), une quatrième borne d'entrée de signal d'horloge (CLK4) et une borne de sortie de signal de grille (OUTPUT),
l'unité de charge (11) étant couplée à la borne d'entrée de signal de grille (INPUT), à la première borne d'entrée de signal d'horloge (CLK1), à l'unité d'élévation (12) et au circuit d'abaissement (13) respectivement de manière à commander un potentiel d'un noeud d'élévation (PU) à un niveau élevé en réponse à un premier signal d'horloge fourni sur la première borne d'entrée de signal d'horloge (CLK1) pendant une phase de charge ;
l'unité d'élévation (12) étant couplée à l'unité de charge (11), au circuit d'abaissement (13), à la deuxième borne d'entrée de signal d'horloge (CLK2) et à la borne de sortie de signal de grille (OUTPUT) respectivement de manière à délivrer l'entrée de signal de niveau élevé par la deuxième borne d'entrée de signal d'horloge (CLK2) à la borne de sortie de signal de grille (OUTPUT) sous contrôle des potentiels du noeud d'élévation (PU) durant une phase de sortie ; et
le circuit d'abaissement (13) étant couplé à l'unité de charge (11), à l'unité d'élévation (12), à la borne d'entrée de signal de niveau bas DC (VSS), à la troisième borne d'entrée de signal d'horloge (CLK3) et à la quatrième borne d'entrée de signal d'horloge (CLK4) respectivement afin de commander des potentiels du noeud d'élévation (PU) et de la borne de sortie de signal de grille (OUTPUT) à un niveau bas durant une phase de réinitialisation et une phase de maintien de réinitialisation,
le circuit d'abaissement (13) comprenant une première unité d'abaissement (131) et une deuxième unité d'abaissement (132), la première unité d'abaissement (131) étant couplée à la troisième borne d'entrée de signal d'horloge (CLK3) et à la borne d'entrée de signal de niveau bas DC (VSS) respectivement afin de commander des potentiels du noeud d'élévation (PU) et de la borne de sortie de signal de grille (OUTPUT) au niveau bas pendant la phase de réinitialisation ; et la deuxième unité d'abaissement (132) étant couplée à la quatrième borne d'entrée de signal d'horloge (CLK4) et à la borne d'entrée de signal de niveau bas DC (VSS) respectivement de manière à commander les potentiels du noeud d'élévation (PU) et de la borne de sortie de signal de grille (OUTPUT) au niveau bas pendant la phase de maintien de la réinitialisation,
le registre à décalage comprenant en outre une borne d'entrée de signal de niveau élevé DC (VDD) ; **caractérisée en ce que**
la première unité d'abaissement (131) comprend un quatrième transistor à couche mince (M4), un cinquième transistor à couche mince (M5), un huitième transistor à couche mince (M8) et un dixième transistor à couche mince (M10), la source du quatrième transistor à couche mince (M4) étant couplée à l'unité de charge (11), à l'unité d'élévation (12) et à la grille du dixième transistor à couche mince (M10) respectivement via le noeud d'élévation (PU), la grille du quatrième transistor à couche mince (M4) étant couplée au drain du huitième transistor à couche mince (M8) et à la source du dixième transistor à couche mince (M10) respectivement, et le drain du quatrième transistor à couche mince (M4) étant couplé à la borne d'entrée de signal bas niveau DC (VSS) ; la source du cinquième transistor à couche mince (M5) étant couplée à l'unité d'élévation (12) et à la borne de sortie de signal de grille (OUTPUT) respectivement, la grille du cinquième transistor à couche mince (M5) étant couplée au drain du huitième transistor à couche mince (M8) et à la source du dixième transistor à couche mince (M10) respectivement, et le drain du cinquième transistor à couche mince (M5) étant couplé à la borne de signal de bas niveau DC (VSS) ; la source du huitième transistor à couche mince (M8) étant couplée à la borne d'entrée de signal de niveau élevé DC (VDD), la grille du huitième transistor à couche mince (M8) étant couplée à la troisième borne d'entrée de signal d'horloge (CLK3), et le drain du huitième transistor à couche mince (M8) étant couplé à la grille du quatrième transistor à couche mince (M4), à la grille du cinquième transistor à couche mince (M5) et à la source du dixième transistor à couche mince (M10) respectivement ; et le drain du dixième transistor à couche mince (M10) étant couplé à la borne d'entrée de signal de bas niveau DC (VSS) ; et
la deuxième unité d'abaissement (132) comprenant un sixième transistor à couche mince (M6), un septième transistor à couche mince (M7), un neuvième transistor à couche mince (M9) et un onzième transistor à couche mince (M11), la source du sixième transistor à couche mince (M6) étant couplée à l'unité d'élévation (12) et la borne de sortie du signal de grille (OUTPUT) respectivement, la grille du sixième transistor à couche mince (M6) étant couplée au drain du neuvième transistor à couche mince (M9) et à la source du onzième transistor à couche mince (M11) respectivement, le drain du sixième transistor à couche mince (M6) étant couplé à la borne d'entrée de signal bas niveau DC (VSS) ; la source du septième transistor à couche mince (M7) étant couplée à l'unité de charge (11), à l'unité d'élévation (12) et à la grille du onzième transistor à couche mince (M11) respectivement via le noeud d'élévation (PU), la grille du septième transistor à couche mince (M7) étant couplée au drain du neuvième transistor à couche mince (M9) et à la source du onzième transistor à couche mince (M11) respectivement, le drain du septième transistor à couche mince (M7) étant couplé à la borne d'entrée de signal bas niveau DC (VSS) ; la source du neuvième transistor à couche mince (M9) étant couplée à la borne d'entrée de signal de niveau élevé DC (VDD), la grille du neuvième transistor à couche mince (M9) étant couplée à la quatrième borne d'entrée de signal d'horloge (CLK4), le drain du neuvième transistor à couche mince (M9) étant couplé à la grille du sixième transistor à couche mince (M6), à la grille du septième transistor à couche mince (M7) et à la source du onzième transistor à couche mince (M11) respectivement ; et le drain du onzième transistor à couche mince (M11) étant couplé à la borne d'entrée de signal bas niveau DC (VSS).

2. Registre à décalage selon la revendication 1, l'unité de charge (11) comprenant un premier transistor à couche mince (M1), la source du premier transistor à couche mince (M1) étant couplée à la borne d'entrée de signal de grille (INPUT), la grille du premier transistor à couche mince (M1) étant couplée à la première borne d'entrée de signal d'horloge (CLK1) et le drain du premier transistor à couche mince (M1) étant couplé à l'unité d'élévation (12) et au circuit d'abaissement (13) respectivement via le noeud d'élévation (PU).

3. Registre à décalage selon la revendication 1, l'unité de charge (11) comprenant un premier transistor à couche mince (M1) et un deuxième transistor à couche mince (M2),
la source du premier transistor à couche mince (M1) étant couplée à la borne d'entrée de signal de grille (INPUT), la grille du premier transistor à couche mince (M1) étant couplée à la première borne d'entrée de signal d'horloge (CLK1), et le drain du premier transistor à couche mince (M1) étant couplé à l'unité de d'élévation (12) et au circuit d'abaissement (13) respectivement via le noeud d'élévation (PU) ;
la source et la grille du deuxième transistor à couche mince (M2) étant couplées à la borne d'entrée de signal de grille (INPUT), le drain du deuxième transistor à couche mince (M2) étant couplé à l'unité d'élévation (12) et au circuit d'abaissement (13) respectivement via le noeud d'élévation (PU).

4. Registre à décalage selon l'une quelconque des revendications 1 à 3, l'unité d'élévation (12) comprenant un troisième transistor à couche mince (M3), la source du troisième transistor à couche mince (M3) étant couplée à la deuxième borne d'entrée de signal d'horloge (CLK2), la grille du troisième transistor à couche mince (M3) étant couplée à l'unité de charge (11) et au circuit d'abaissement (13) respectivement via le noeud d'élévation (PU), et le drain du troisième transistor à couche mince (M3) étant couplé à la borne de sortie de signal de grille (OUTPUT) et au circuit d'abaissement (13) respectivement.

5. Registre à décalage selon l'une quelconque des revendications 1 à 4, l'unité d'élévation (12) comprenant en outre un condensateur de stockage (C1), une première borne du condensateur de stockage (C1) étant couplée à la grille du troisième transistor à couche mince (M3), à l'unité de charge (11) et au circuit d'abaissement (13) via le noeud d'élévation (PU), et une deuxième borne du condensateur de stockage (C1) étant couplée au drain du troisième transistor à couche mince (M3), à la borne de sortie du signal de grille (OUTPUT) et au circuit d'abaissement (13) respectivement.

6. Dispositif d'entraînement de grille, **caractérisé en ce qu'**il comprend plusieurs étages de registres à décalage selon l'une quelconque des revendications 1 à 5 ;
à l'exception du dernier étage des registres à décalage, chaque borne de sortie de signal de grille (OUTPUT) des étages restants des registres à décalage étant couplée à une borne d'entrée de signal de grille (INPUT) de l'étage suivant des registres à décalage.

7. Dispositif d'affichage, **caractérisé en ce qu'**il comprend le dispositif d'entraînement de grille selon la revendication 6.

8. Produit électronique, **caractérisé en ce qu'**il comprend le dispositif d'affichage selon la revendication 7.
